# FASCICULE DE BREVET EUROPEEN

(11) **EP 0 860 904 B1**
(45) Date de publication et mention de la délivrance du brevet: **26.09.2001**
(21) Numéro de dépôt: 98201406.0
(22) Date de dépôt: 07.04.1997
(51) Int. Cl.: H01R 13/514, H01R 13/627

(54) **Connecteur pour le raccordement d'une carte à circuit(s) intégré(s) et boîtier équipé d'un tel connecteur**
Verbinder für IC-Karte und damit ausgerüstetes Gehäuse
Connector for integral circuit card and a housing equipped with the same

(30) Priorité: 18.04.1996 FR 9604842
(43) Date de publication de la demande: 26.08.1998
(62) Demande divisionnaire de: 97923269.1
(73) Titulaire: ITT MANUFACTURING ENTERPRISES, INC., Wilmington, Delaware 19801 (US)
(72) Inventeur: Bricaud, Hervé, 39100 Dole (FR); Biermann, Werner, 73650 Winterbach (DE)
(74) Mandataire: Kohn, Philippe

(56) Documents cités:
- EP-A- 0 595 025
- DE-A- 4 138 342
- DE-B- 2 326 543
- DE-U- 29 505 678

## Description

La présente invention concerne un connecteur pour relier une carte à circuit(s) intégré(s) à contact à un boîtier de raccordement électronique et un tel boîtier équipé d'un tel connecteur.

La connexion d'une carte à puce avec un quelconque dispositif électronique d'exploitation de données qu'elle contient est couramment assurée par l'intermédiaire d'un connecteur de conception générale connue qui comporte un support en matériau isolant comportant un logement ouvert dans sa face supérieure qui reçoit la carte à puce comportant sur sa face principale des plages conductrices qui coopèrent avec les extrémités de contact d'éléments de contact électrique agencées dans le fond du logement du support isolant du connecteur.

L'état de la technique le plus proche est DE-A-4138342 qui décrit un connecteur pour carte dans lequel la carte est retenue par deux rampes fixes situées sur le fond du logement du connecteur.

L'invention a pour but de proposer une nouvelle conception d'un connecteur qui permet de maintenir la carte en position introduite, d'éviter son échappement accidentel.

Dans ce but, l'invention propose un connecteur tel que défini à la revendication 1.

Selon d'autres caractéristiques de l'invention :
- la carte est sollicitée en permanence, par un ressort, selon une direction correspondant à son extraction hors du connecteur ;
- la lèvre est reliée à au moins un bras longitudinal qui par son fléchissement vertical permet des déplacements dans un plan sensiblement vertical de la lèvre ;
- la lèvre s'escamote automatiquement lors de l'introduction de la carte dans la mesure où le bord transversal arrière de la carte coopère avec la lèvre qui agit comme une came pour provoquer la déformation élastique du bras, la lèvre étant alors en appui contre la portion en vis-à-vis de la carte ;
- la carte comporte au voisinage de son bord transversal avant un pan coupé qui constitue un moyen de détrompage de la position de la carte dans le connecteur, et la lèvre comporte une découpe de profil complémentaire de celui du bord transversal avant de la carte avec un pan coupé ;
- le support en matériau isolant comporte un logement ouvert dans sa face supérieure, délimité par deux bords parallèles à la direction d'introduction de la carte et transversalement par au moins un bord arrière et qui reçoit au moins en partie la carte comportant sur sa face principale inférieure des plages conductrices qui coopèrent avec les extrémités de contact d'éléments de contact électrique, agencées dans le fond du logement du support, lorsque la carte est dans sa position de raccordement dans laquelle son bord transversal arrière est en butée contre le bord transversal arrière du logement ;
- des moyens d'extraction de la carte comportent une entaille formée dans une paroi supérieure et qui s'étend parallèlement à la direction d'introduction de la carte pour permettre d'agir sur la carte en vue de provoquer son coulissement à l'intérieur du logement dans le sens correspondant à son extraction ;
- l'entaille s'étend au moins en partie au droit du bord transversal arrière de la carte lorsque cette dernière est en position introduite pour permettre l'introduction d'un outil d'extraction qui coopère avec le bord transversal arrière de la carte ;
- des moyens d'extraction de la carte comportent un chariot d'extraction monté coulissant sur le support du connecteur, entre une position introduite de la carte et une position d'extraction dans laquelle la carte fait au moins en partie saillie à l'extérieur, le chariot d'extraction comporte un bord transversal actif qui s'étend en regard du bord transversal arrière de la carte et en ce qu'il est prévu des moyens de commande des déplacements en coulissement du chariot accessibles depuis l'extérieur ;
- le chariot d'extraction est rappelé élastiquement vers la position d'extraction de la carte.

L'invention propose aussi un boîtier tel que défini à la revendication 11.

Selon d'autres caractéristiques du boîtier :
- en position introduite, la carte est agencée entièrement à l'intérieur du boîtier ;
- en position introduite dans le boîtier, et ainsi en position de raccordement dans le logement du connecteur, le bord transversal avant de la carte est situé entièrement à l'intérieur du boîtier , c'est-à-dire légèrement en retrait vers l'intérieur par rapport au bord principal de la fente d'introduction ;

D'autres caractéristiques et avantages de l'invention apparaîtront à la lecture de la description détaillée qui suit pour la compréhension de laquelle on se reportera aux dessins annexés dans lesquels :
- la figure 1 est une vue en perspective éclatée des principaux composants d'un boîtier équipé d'un connecteur pour le raccordement d'une carte ;
- la figure 2 est une vue de détail en perspective du boîtier illustré à la figure 1 qui illustre à plus grande échelle l'agencement de la fente d'introduction de la carte dans le boîtier ;
- la figure 3 est une vue de dessus d'un exemple de réalisation, non couvert par l'invention, d'un connecteur pour carte à puce destiné à être intégré dans un boîtier;
- la figure 4 est une vue latérale selon la flèche F4 de la figure 3 ;
- La figure 5 est une vue latérale selon la flèche F5 de la figure 3 ;
- la figure 6 est une vue de dessus, avec arrachements partiels, du boîtier de raccordement et qui illustre l'implantation du connecteur sur la plaque à circuit imprimé et à proximité de la fente d'introduction de la carte ;
- la figure 7 est une vue en section partielle selon la ligne 7-7 de la figure 6 ;
- la figure 8 est une vue similaire à celle de la figure 3 qui illustre un autre exemple de réalisation, non couvert par l'invention, du connecteur qui est ici équipé d'une première variante de réalisation du chariot d'extraction de la carte et sur laquelle le chariot et la carte sont représentés en position introduite de la carte et sont aussi représentés en silhouette en position partiellement extraite de la carte ;
- les figures 9 et 10 sont des vues similaires à celles des figures 4 et 5 selon les flèches F9 et F10 de la figure 8 ;
- la figure 11 est une vue similaire à celle de la figure 8 qui illustre un autre exemple de réalisation, non couvert par l'invention, du connecteur qui est ici équipé d'une deuxième variante de réalisation du chariot d'extraction de la carte et sur laquelle le chariot et la carte sont représentés en position introduite de la carte et sont aussi représentés en silhouette en position partiellement extraite de la carte ;
- la figure 11A est une vue en perspective selon la flèche F11A de la figure 11 qui illustre à plus grande échelle la conception du chariot d'extraction ;
- la figure 12 est une vue en perspective d'un exemple de réalisation, non couvert par l'invention, du support en matériau isolant du connecteur destiné à être équipé des moyens d'obturation de la fente illustrés à la figure 13 ;
- la figure 13 est une vue en perspective du dispositif d'obturation destiné à équiper le connecteur dont l'isolant est représenté à la figure 12 ;
- la figure 14 est une vue similaire à celle de la figure 6 qui illustre le connecteur et le dispositif d'obturation représentés aux figures 12 et 13 avec la carte en position introduite ;
- la figure 15 est une vue similaire à celle de la figure 7, en section partielle selon la ligne 15-15 de la figure 14 ;
- la figure 16 est une vue similaire à celle de la figure 15 sans la carte ;
- les figures 17 et 18 sont des vues similaires à celles des figures 15 et 16 qui illustrent, selon un mode de réalisation du connecteur de l'invention, une variante de réalisation du dispositif d'obturation qui fait aussi fonction, conformément aux enseignements de l'invention, de dispositif de verrouillage de la carte en position introduite dans le boîtier ;
- la figure 19 est une vue similaire à celle de la figure 18 qui illustre, selon un autre mode de réalisation du connecteur de l'invention, une autre variante de réalisation du dispositif de verrouillage et d'obturation illustré à la figure 18 en association avec une variante de réalisation du chariot d'extraction automatique illustré à la figure 11 ;
- la figure 20 est une vue similaire à celle de la figure 18 qui illustre, selon un autre mode de réalisation du connecteur de l'invention, une autre variante de réalisation des moyens de verrouillage de la carte et du chariot en position carte introduite ; et
- la figure 21 est une vue selon la ligne 21-21 de la figure 20.

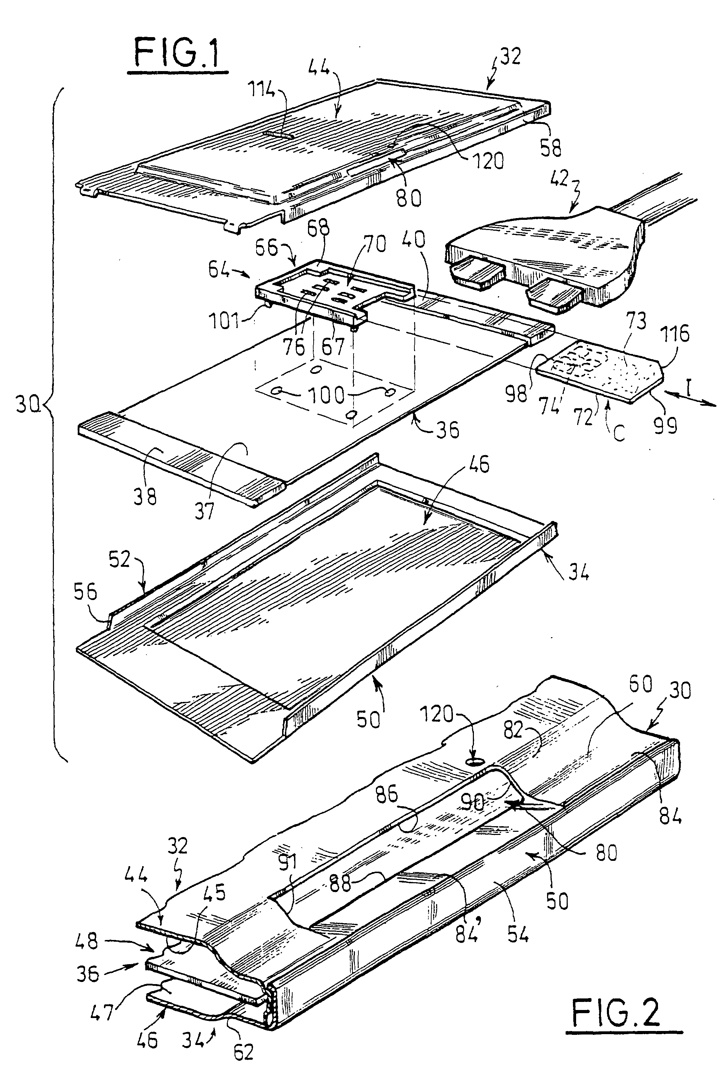

On a représenté à la figure 1 un boîtier 30, de conception générale connue, qui est essentiellement constitué par une coquille métallique comportant une demi-coquille supérieure 32 et une demi-coquille inférieure 34 dont chacune est une pièce en tôle découpée, emboutie et pliée.

Les formes et les dimensions de la coquille en deux parties 32, 34 sont conformes à la norme PCMCIA qui, outre ses dimensions, détermine aussi les détails de conformation de la coquille de manière à permettre son introduction dans une fente normalisée (non représentée) de forme complémentaire appartenant par exemple à un ordinateur personnel.

A l'intérieur du boîtier 30, entre les demi-coquilles 32 et 34, est agencé une plaque à circuit imprimé 36 qui s'étend parallèlement au plan général du boîtier et qui porte, à chacune de ses extrémités longitudinales opposées, des connecteurs 38, 40, illustrés de manière schématique sur la figure 1, l'un ou l'autre des connecteurs pouvant, selon les applications, être remplacé par un élément de même dimension constituant un bouchon de fermeture du boîtier 30 à son extrémité longitudinale correspondante.

La plaque à circuit imprimé qui constitue la plaque intermédiaire du boîtier peut recevoir, sur ses deux faces, des composants électroniques (non représentés).

Comme on l'a représenté sur la figure 1, l'un des connecteurs 40 peut par exemple être conçu pour permettre le branchement d'une prise 42 qui assure le raccordement du boîtier 30 par exemple avec une ligne de télécommunication.

La demi-coquille supérieure 32 délimite une paroi principale supérieure plane 44 qui, en coopération avec la paroi principale inférieure plane 46 de la demi-coquille inférieure 34, délimite une cavité interne 48 (voir figure 2) à l'intérieur de laquelle s'étend la plaque à circuit imprimé 36, parallèlement aux parois 44 et 46 et sensiblement à mi-hauteur entre les faces internes en vis-à-vis 45 et 47 des parois 44 et 46.

Selon la conception normalisée du boîtier 30, celui-ci est délimité transversalement par deux parois latérales opposées 50 et 52, qui sont parallèles à la direction générale longitudinale du boîtier 30 et qui sont ici constituées par des bords rabattus verticaux 54 et 56 de la demi-coquille inférieure 34 qui sont sertis autour des bords latéraux en vis-à-vis de la demi-coquille supérieure 32 dont l'un 58 est illustré à la figure 1.

Le boîtier 30 peut être réalisé avec une coquille en une seule pièce.

Les parois latérales 50 et 52 du boîtier de raccordement 30 sont conformées en forme de rails de guidage du boîtier 30 dans des glissières correspondantes (non représentées) appartenant à la fente normalisée destinée à recevoir le boîtier 30.

A cet effet, les portions d'extrémité latérale des demi-coquilles supérieure 32 et inférieure 34 sont déformées 60, 62 pour conférer aux parois latérales 50 et 52 une hauteur réduite par rapport à la hauteur globale du boîtier 30, c'est-à-dire son épaisseur dans sa partie centrale.

Un connecteur 64 destiné à recevoir une carte C à circuit(s) intégré(s) à contact du type "MICRO SIM" est agencé à l'intérieur du boîtier 30.

Selon une conception connue, qui est par exemple décrite et représentée dans la demande de brevet français FR-A-2742561, le connecteur 64 est constitué pour l'essentiel par un support en matériau isolant 66 qui délimite dans sa face supérieure 68 un logement 70 de forme complémentaire de celui de la carte C et qui est destiné à recevoir au moins en partie cette dernière dont la face inférieure 72 comporte des plages conductrices 74 qui, lorsque la carte C est en position introduite dans le logement 70, sont en contact avec des extrémités de contact 76 appartenant à des lames de contact 78 du connecteur.

Le connecteur 66 est prévu pour être monté avec la face inférieure 67 de l'isolant 66 en appui sur la face supérieure 37 de la plaque à circuit imprimé 36.

Une fois le boîtier 30 assemblé et fermé avec le connecteur 64 porté par la plaque à circuit imprimé 10 et afin de permettre l'introduction et ou l'extraction de la carte C dans le connecteur 64, il est prévu une fente 80 qui, dans le mode de réalisation préféré illustré aux figures, est agencée au voisinage de l'une des parois latérales 50 du boîtier de raccordement 30.

Plus particulièrement, et comme on peut le voir en détail sur la figure 2, la fente d'introduction 80 s'étend pour l'essentiel dans la portion inclinée 82 de la partie latérale de la demi-coquille supérieure 32 qui relie la paroi principale supérieure 44 au pli 60 qui s'étend dans la portion plane 84 correspondant à la portion latérale d'épaisseur réduite du boîtier 30.

La portion 84' de la partie 84, qui s'étend au droit de la fente 80 découpée dans la partie inclinée 82, est légèrement déformée verticalement vers le bas par rapport au plan général de la partie 84.

La fente d'introduction 80 est ainsi délimitée par deux bords principaux supérieurs 86 et 88 et par deux bords d'extrémité 90 et 92.

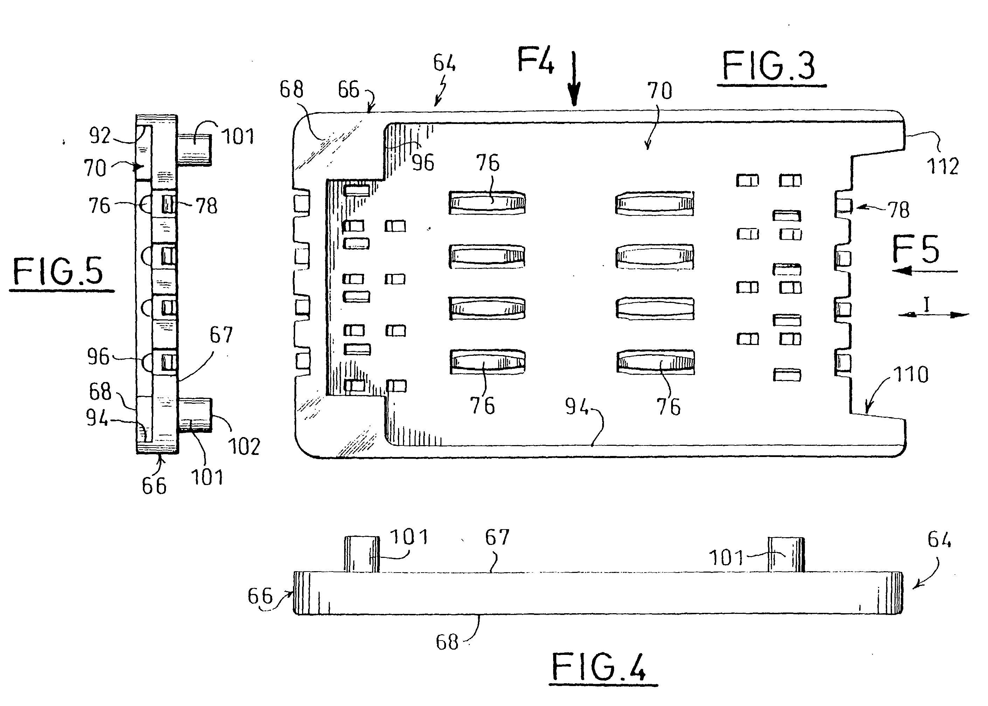

Dans le connecteur 64 illustré aux figures 3 à 5, celui-ci comporte, sur sa face inférieure 67, quatre pieds 101 en forme de pions cylindriques qui sont destinés, d'une part, à assurer le positionnement et la fixation du connecteur 64 sur la plaque à circuit imprimé 36, qui comporte à cet effet des trous correspondants 100 à travers laquelle s'étendent les pieds 101 et, d'autre part, à permettre au connecteur 64 d'assurer une fonction d'entretoise entre les plaques principales supérieure 44 et inférieure 46 du boîtier 30 afin d'éviter un écrasement intempestif du boîtier 30.

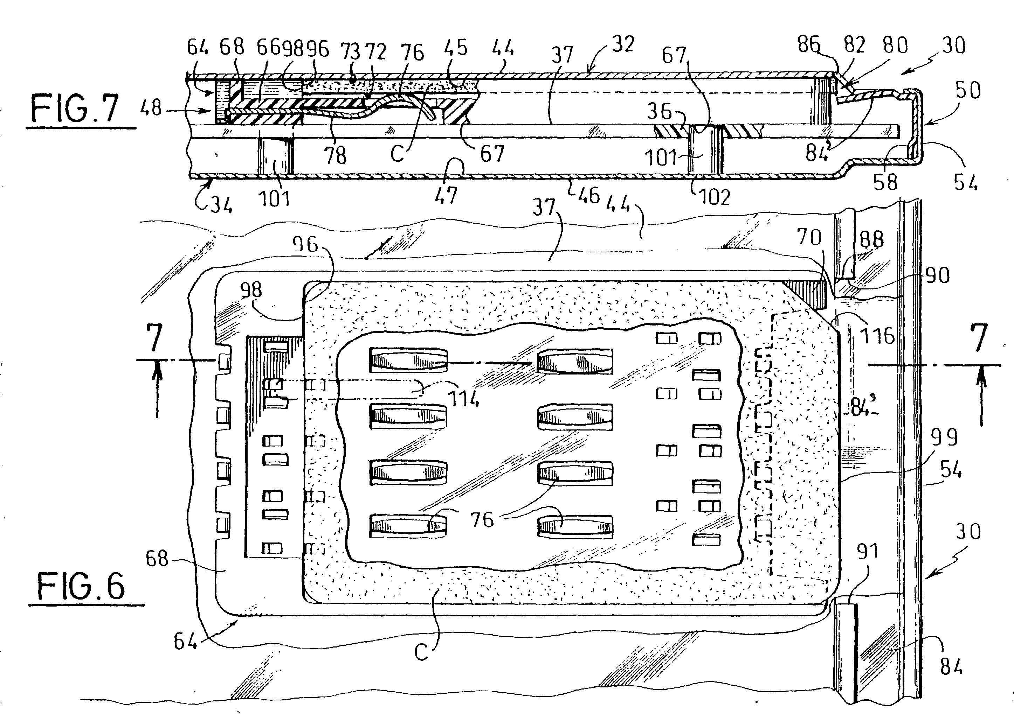

A cet effet, et comme on peut le voir notamment sur la figure 7, la hauteur des pieds 101 en forme de pions cylindriques formant entretoise est telle que la face d'extrémité inférieure 102 de chaque pied 101 est en contact avec la face interne 47 de la paroi inférieure 46 tandis que la face supérieure plane 68 du support isolant 66 du connecteur 64 est en appui contre la face interne en vis-à-vis 45 de la paroi supérieure 44.

Comme on peut le voir à la figure 3, la conception du connecteur 64, qui comporte un dégagement 110 formé dans son bord avant 112, et son positionnement sur la carte à circuit imprimé 36, par rapport à la fente 80, sont tels que les extrémités de raccordement des lames de contact 78 sont situées en retrait par rapport à la zone d'accès constituée par la fente 80 évitant ainsi tout risque de court-circuit accidentel en cas d'introduction d'un objet métallique dans la fente 80.

Comme on peut le voir aussi aux figures 6 et 7, lorsque la carte C est en position introduite dans le boîtier et ainsi en position de raccordement dans le logement 70 du connecteur 64, son bord transversal avant 99 est situé entièrement à l'intérieur du boîtier 30, c'est-à-dire légèrement en retrait vers l'intérieur par rapport au bord principal supérieur 86 de la fente d'introduction 80. Afin de faciliter l'introduction à fond de la carte, on peut prévoir une découpe supplémentaire dans le bord de la fente 80.

Le boîtier 30 équipé du connecteur 64 présente ainsi une "silhouette" extérieure, après introduction de la carte C, qui est identique à celle d'un boîtier classique de manière à permettre son introduction dans une fente correspondante d'un ordinateur personnel.

Les dimensions extrêmement réduites de la fente d'introduction 80 ne modifient pas la structure générale du boîtier 30, c'est-à-dire ni sa rigidité, et la fente n'affecte pas la fonction de blindage électromagnétique que le boîtier assure par rapport aux composants (non représentés) portés par la plaque à circuit imprimé 36.

Selon les exemples illustrés aux figures 1 à 7, afin de permettre l'extraction de la carte C hors du boîtier 30, il est prévu dans la plaque principale supérieure 44 une entaille ou rainure d'extraction 114, qui est illustrée en trait mixte à la figure 6, qui s'étend transversalement par rapport au boîtier 30, c'est-à-dire parallèlement à la direction I d'introduction ou d'extraction de la carte. L'entaille 114 est positionnée de manière à s'étendre de part et d'autre du bord transversal arrière 98 de la carte C et, de préférence, en vis-à-vis d'une zone du connecteur 64 ne comportant pas de parties métalliques appartenant aux lames de contact 78.

Ainsi, il est possible d'introduire un outil de petite dimension dans l'entaille 114 pour agir sur le bord transversal arrière 98 de la carte C afin de la repousser hors de son logement 70, c'est-à-dire en la faisant coulisser de la gauche vers la droite en considérant la figure 6, sur la course permise par la longueur de l'entaille 114 de manière que son bord transversal avant 99 sorte au moins en partie du boîtier 30 par la fente 80 de façon que, à l'issue de cette première phase d'extraction, l'utilisateur puisse attraper la carte pour l'extraire entièrement du boîtier 30.

Selon la définition normalisée des cartes "MICRO SIM", dont un exemple est illustré dans le cadre de la présente description, la carte C comporte au voisinage de son bord transversal avant 99 un pan coupé 116 qui, pour certaines applications, constitue un moyen de détrompage de la position de la carte C dans son connecteur.

Afin de maintenir la carte C en position introduite dans le boîtier 30 et éviter son échappement accidentel hors du boîtier, même partiel, il peut être prévu un bossage 120 formé dans la paroi principale supérieure 44 au droit du pan coupé 116 et qui s'étend, sur une faible hauteur, à l'intérieur de la cavité 48, pour constituer une butée qui s'étend en regard du pan coupé 116.

Lors de l'extraction de la carte au moyen d'un outil introduit dans l'entaille 114, l'utilisateur doit appliquer un effort légèrement plus important de manière que, par une légère déformation élastique de la partie correspondante de la paroi supérieure 44, la butée constituée par le bossage 120 s'efface lors du passage du pan coupé 116 puis de la face supérieure 73 de la carte C.

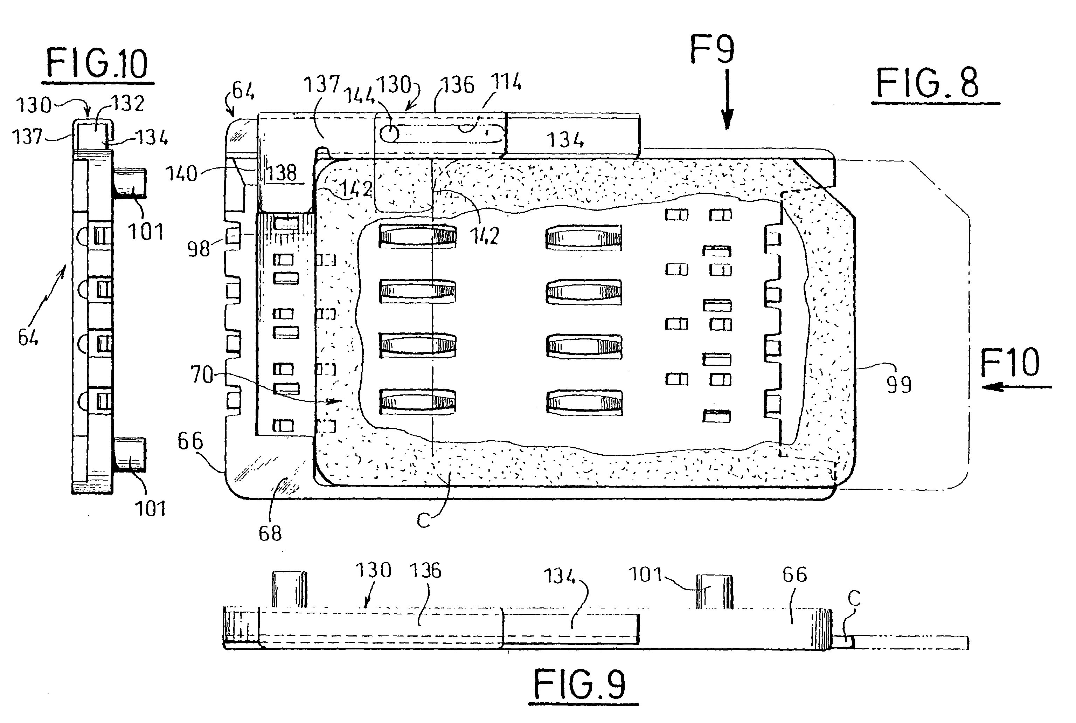

On décrira maintenant les exemples illustrés aux figures 8 à 10 selon lequel le connecteur 64, qui est d'une conception légèrement différente à celle décrite et représentée précédemment, est équipé d'un chariot 130 d'extraction manuelle de la carte C.

A cet effet, le support en matériau isolant 66 du connecteur 64 comporte, sur l'un de ses bords latéraux 132, une glissière 134 sur laquelle est montée coulissante la portion latérale 136, en forme de coulisseau, du chariot d'extraction 130 qui se prolonge par une patte d'extraction 138 qui s'étend au-dessus de la face supérieure 68 du support 66, dans le plan correspondant à l'épaisseur de la carte C.

La patte d'extraction 138 est délimitée par un bord transversal arrière 140 qui, lorsque le chariot d'extraction est en position "carte introduite" (comme cela est représenté en trait fort à la figure 8), est en butée contre le bord transversal arrière 96 du logement 70. La patte 138 est aussi délimitée par un bord transversal avant 142 contre lequel vient en appui le bord transversal arrière 98 de la carte C.

Le chariot d'extraction 130 peut coulisser depuis sa position carte introduite, de la gauche vers la droite en considérant la figure 8, vers une position d'extraction de la carte C au cours de laquelle il provoque un déplacement simultané de la carte C du fait de la coopération du bord 142 de la patte 138 avec le bord transversal arrière 98 de la carte.

Afin d'entraîner en coulissement le chariot d'extraction 130, sa partie formant coulisseau 136 comporte une creusure 144 destinée à recevoir l'extrémité d'un outil de forme complémentaire qui est introduit dans une entaille de la face supérieure 44 du boîtier 30, qui est une entaille similaire à l'entaille 114 décrite précédemment mais qui s'étend alors en regard du coulisseau 136.

Cette conception est particulièrement avantageuse en ce qu'elle évite d'agir directement avec un outil sur le bord transversal arrière 98 de la carte C en évitant ainsi de détériorer la carte.

De plus, la face supérieure en forme de plaque 137 du coulisseau métallique 130 s'étend toujours en regard de l'entaille 114 assurant ainsi une fermeture électromagnétique de l'entaille 114.

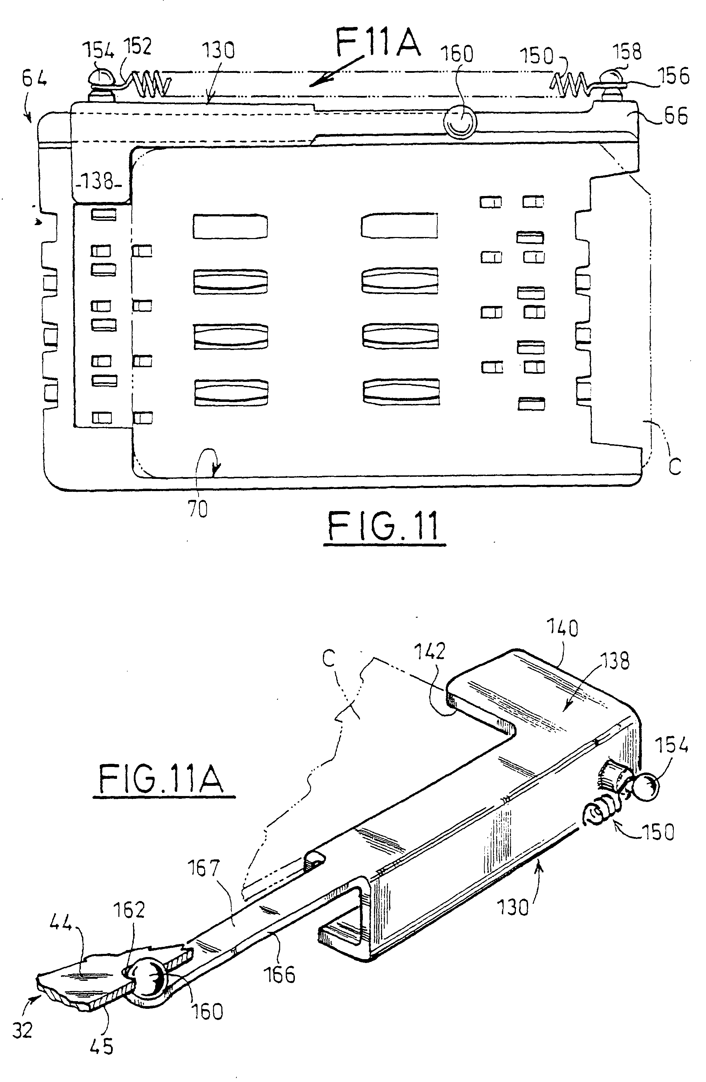

On décrira maintenant les exemples illustrés aux figures 11 et 11A dans lequel le connecteur 64 est équipé d'un chariot 130 d'extraction de la carte qui assure une extraction automatique de cette dernière.

A cet effet, la conception du chariot d'extraction 130 est similaire à celle qui a été décrite en référence aux figures 8 à 10 mais il est équipé d'un ressort hélicoïdal de traction 150 qui le rappelle élastiquement en permanence vers une position d'extraction de la carte.

A cet effet, un première extrémité 152 du ressort est accrochée sur un ergot 154 appartenant au coulisseau 130 tandis que son extrémité opposée 156 est accroché, sur un ergot 158 réalisé venu de matière avec l'isolant 66 du connecteur 64.

Du fait de la présence du ressort de traction 150, la carte C, illustrée en silhouette à la figure 11, est sollicitée en permanence par la patte d'extraction 138, de la gauche vers la droite, c'est-à-dire selon une direction correspondant à son extraction hors du connecteur 64 et donc hors du boîtier 30.

Afin de maintenir la carte en position introduite, c'est-à-dire dans la position dans laquelle elle est illustrée en silhouette à la figure 11, il existe un moyen de verrouillage en position "carte introduite" du chariot d'extraction 130 qui est ici constitué par un doigt de verrouillage 160 qui est prévu pour être reçu en position "carte introduite", dans un trou complémentaire 162 formé en vis-à-vis dans la paroi principale supérieure 44 du boîtier 30, comme cela est illustré à la figure 11A.

Le doigt 160 est par exemple constitué par un bossage ou par une bille agencée à l'extrémité d'un bras 166 qui prolonge le corps principal du chariot d'extraction 130, dans le plan de la face supérieure 137 de ce dernier, la poutre constituée par le bras 166 pouvant être fléchie par déformation élastique verticalement vers le bas afin de faire échapper le doigt de verrouillage 160 hors du trou 162 par l'intermédiaire d'un outil (non représenté) au moyen duquel on appuie sur le doigt 160 qui est alors effacé vers l'intérieur du boîtier permettant une extraction automatique de la carte sous l'action du ressort 150, le doigt 160 frottant, au cours de la course d'extraction, contre la face interne en vis-à-vis 45 de la paroi principale supérieure 44.

Outre qu'elle permet d'assurer une extraction automatique de la carte, la conception du chariot d'extraction automatique 130 associé à un ressort d'extraction 150 permet de supprimer l'entaille 114 dans le boîtier 30 et de la remplacer par un simple trou 162 de petite dimension qui est obturé soit par l'extrémité du bras 166 constituant le doigt de verrouillage 160, soit par une portion en vis-à-vis de la face supérieure 167 du bras 166, au cours de la course d'extraction du chariot 130.

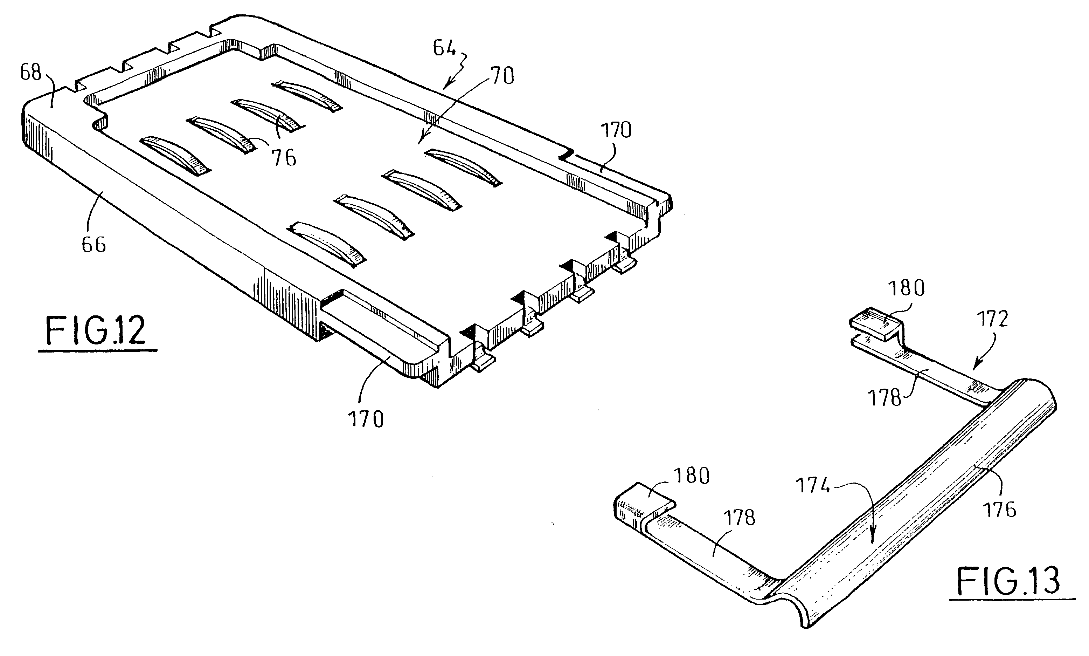

On décrira maintenant en référence aux figures 12 à 16 un premier exemple de réalisation de moyens d'obturation au moins partiel de la fente d'introduction 80.

A cet effet, le support en matériau isolant 66 du connecteur 64 est modifié dans sa partie avant, à droite en considérant la figure 12, pour comporter deux nervures longitudinales opposées 170 pour le montage en position fixe d'un dispositif d'obturation 172.

Le dispositif 172 est constitué pour l'essentiel par une lèvre d'obturation 174 de profil général incurvé semi-cylindrique creux dont la face supérieure convexe 176 est orientée vers le haut pour venir s'étendre à proximité et en regard de la fente 80.

La lèvre d'obturation 174 est reliée à deux bras parallèles longitudinaux et opposés 178 dont chacun porte à son extrémité libre une patte 180 pour l'accrochage du dispositif d'obturation 172 sur le connecteur 164 par insertion des nervures 170 dans les pattes d'accrochage recourbées en U.

Le dispositif d'obturation 172 est par exemple réalisé par découpage et emboutissage d'une tôle métallique de faible épaisseur.

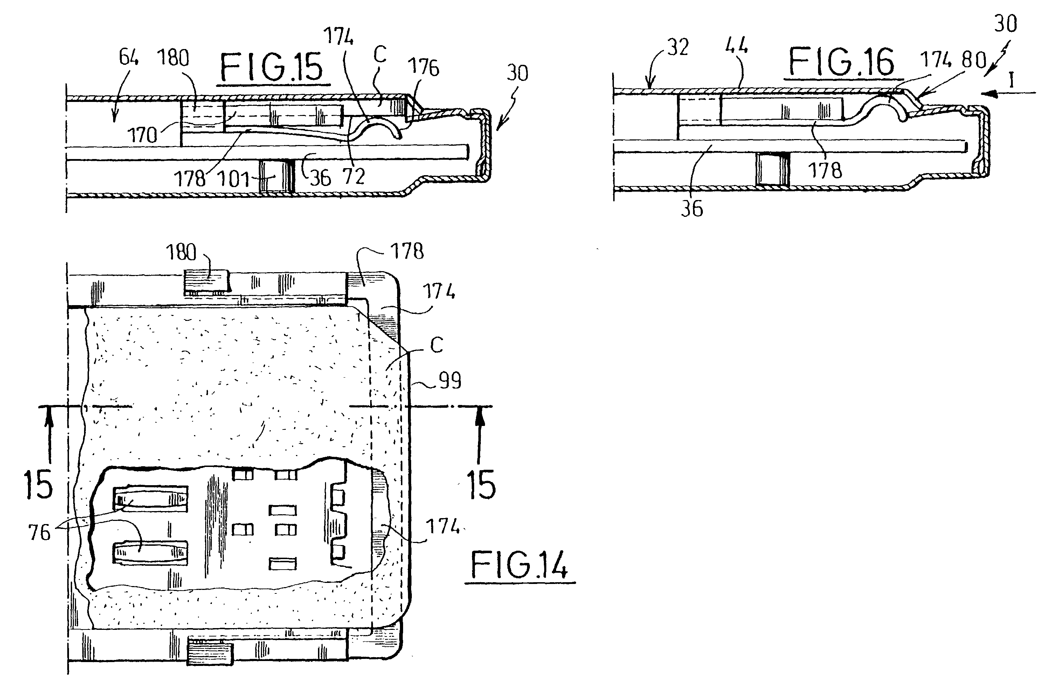

Comme on peut le voir aux figures 14 à 16, les bras 178 qui portent la lèvre d'obturation 174 s'étendent dans le plan des faces inférieures des nervures 170 et, par leur fléchissement vertical, ils permettent des déplacements dans un plan sensiblement vertical de la lèvre 174, entre sa position normalement effacée vers le bas lorsque la carte C est en place dans le connecteur 64 et une position normale de repos illustrée à la figure 16, dans laquelle, en l'absence de carte, la lèvre 174 s'étend devant la fente 80 qui est ici de dimension légèrement supérieure à celle illustrée précédemment, c'est-à-dire qu'elle s'étend légèrement vers l'intérieur du boîtier, dans la face supérieure 44 de la demi-coquille 32.

La lèvre d'obturation 174 s'escamote automatiquement lors de l'introduction de la carte C selon la direction I dans la mesure où le bord transversal arrière 98 de la carte C coopère avec la face supérieure 176 qui agit comme une came pour provoquer la déformation élastique des bras 178, la lèvre 174 étant alors en appui contre la portion en vis-à-vis de la face inférieure 72 de la carte C.

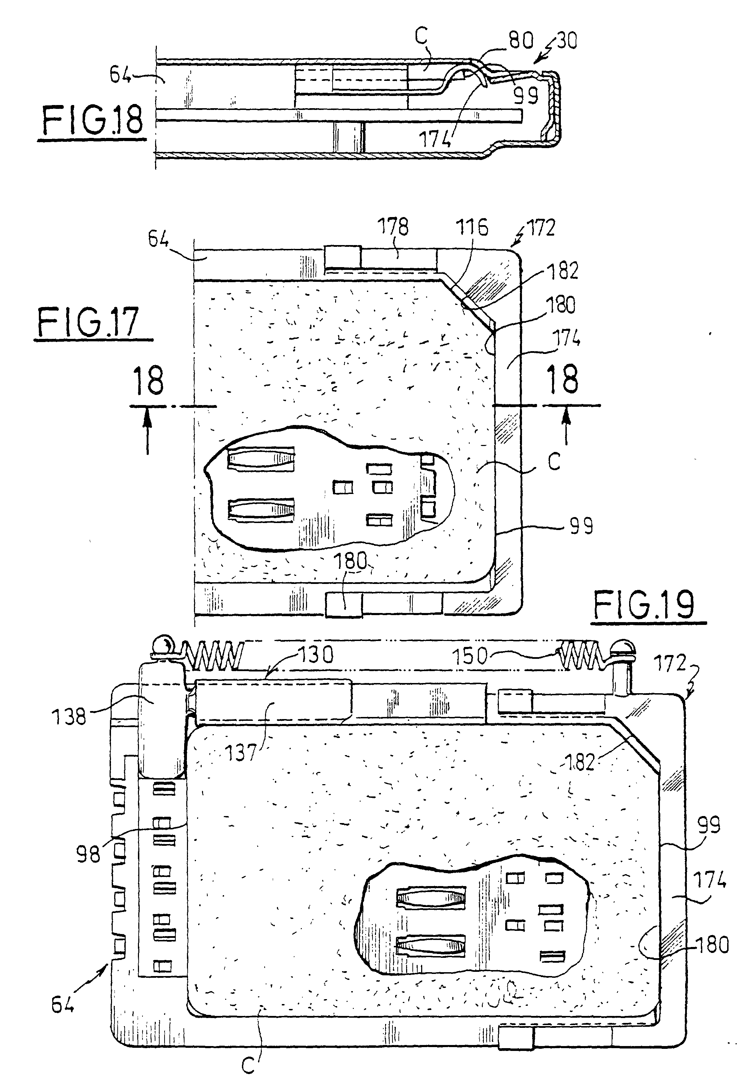

On décrira maintenant un mode de réalisation du connecteur selon l'invention illustré aux figures 17 et 18 sur lesquelles le dispositif 172 d'obturation constitue aussi un dispositif de retenue de la carte C en position introduite dans le connecteur 64 et dans le boîtier 30.

A cet effet, la longueur des bras 178 est légèrement supérieure et la lèvre 174 comporte une découpe arrière 180 de profil complémentaire de celui du bord transversal avant 99 de la carte C avec un pan coupé 182.

En position introduite de la carte, le bord de la découpe arrière 180 s'étend en vis-à-vis du bord transversal avant 99 de la carte C et il est donc impossible d'extraire la carte, le dispositif d'obturation 172 assurant ainsi une fonction de verrouillage de la carte C en position introduite et évitant alors tout échappement accidentel de la carte.

Pour extraire la carte, quel que soit le mode d'extraction manuel ou automatique, il est nécessaire de provoquer un déverrouillage de celle-ci en agissant à travers la fente 80 au moyen d'un outil (non représenté) sur la lèvre 174 pour provoquer un déplacement vertical vers le bas de cette dernière jusqu'à ce qu'elle passe en-dessous du plan de la carte C pour libérer cette dernière qui peut alors coulisser, de la gauche vers la droite en considérant les figures 17 et 18 à l'extérieur du boîtier 30.

Dans la variante de réalisation du connecteur de l'invention illustrée à la figure 19, le dispositif d'obturation 172 est similaire à celui illustré aux figures 17 et 18 mais il est associé à un chariot d'extraction 130 du type de celui décrit et représenté aux figures 11 et 11A, l'ergot 158 pour l'accrochage du ressort d'extraction 150 étant réalisé venu de matière avec le dispositif d'obturation 172.

Grâce à cette conception, le chariot d'extraction automatique 130 peut être simplifié dans la mesure où il n'est pas nécessaire qu'il comporte ses propres moyens de verrouillage en position introduite de la carte, le verrouillage étant assuré par le dispositif d'obturation 172, la carte étant en permanence sollicitée par le chariot d'extraction 130 de manière que son bord transversal avant 99 soit en butée contre le bord de la découpe arrière 180 de la lèvre 174.

Pour provoquer l'extraction automatique de la carte C, il suffit d'agir, comme dans le cas du mode de réalisation décrit en référence aux figures 17 et 18, sur la lèvre 174 à travers le fente 80. pour provoquer l'effacement de la lèvre 174 et l'extraction automatique de la carte C qui est alors sollicitée de la gauche vers la droite en considérant la figure 19 par le chariot d'extraction 130.

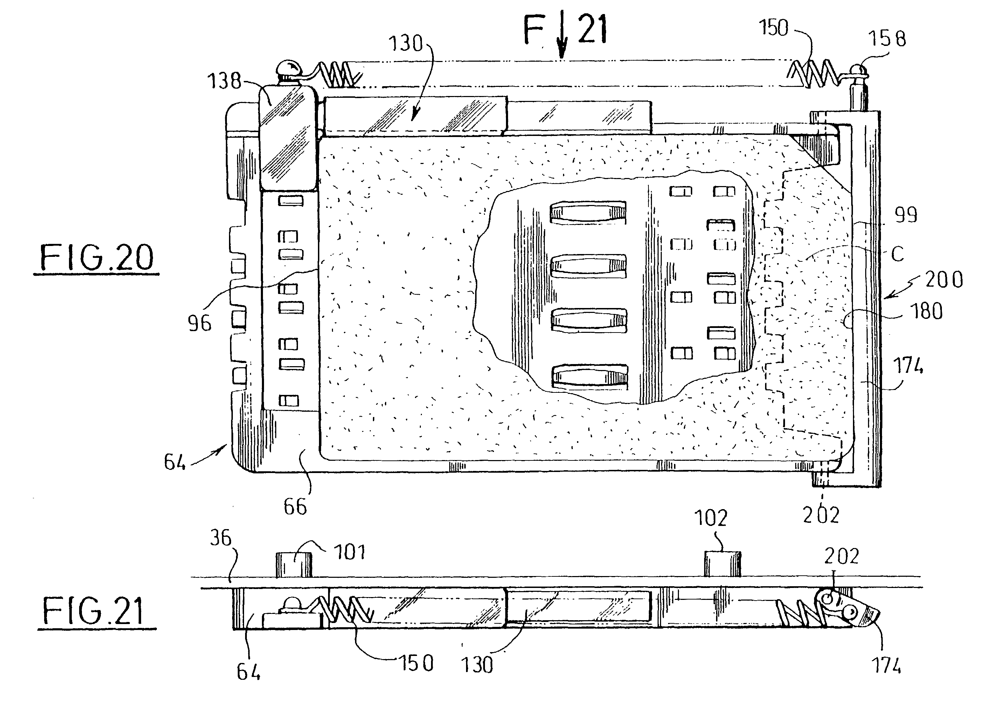

Dans le mode de réalisation du connecteur de l'invention illustré aux figures 20 et 21, le dispositif de verrouillage de la carte est constitué par une bascule 200 montée pivotante sur l'isolant 66 du connecteur 64 autour d'un axe 202, le ressort d'extraction 150 étant accroché sur un ergot qui est porté par la bascule 200 de manière à solliciter cette dernière en permanence dans la position de verrouillage de la carte dans laquelle la découpe arrière 180 de la bascule 200 s'étend en regard du bord transversal avant 99 de la carte C lorsque cette dernière est en position introduite, comme cela est illustré notamment sur la figure 20.

La face supérieure 174 de la bascule 200 assure une fonction équivalente à celle de la lèvre d'obturation 174 dans la mesure où elle peut s'étendre dans la fente d'obturation 80.

## Revendications

1. Connecteur (64), pour relier électriquement une carte à circuit(s) intégré(s) à contact (C) à un boîtier de raccordement électronique, qui comporte un support (66) en matériau isolant, ledit connecteur comportant un dispositif (172) de retenue de la carte en position introduite dans le connecteur, et **caractérisé en ce que** le connecteur comporte une lèvre (174) ayant une découpe de profil complémentaire de celui du bord transversal avant (99) de la carte, la découpe et ledit bord transversal avant se faisant face en position introduite, et en ce que pour extraire la carte, quel que soit le mode d'extraction manuel ou automatique, il est nécessaire de provoquer un déverrouillage de celle-ci en agissant sur la lèvre (174) pour provoquer un déplacement de la lèvre dans une direction orthogonale au plan de la carte en position introduite pour libérer la carte.

2. Connecteur selon la revendication précédente, **caractérisé en ce que**, dans le connecteur, la carte (C) est sollicitée en permanence, par un ressort, selon une direction correspondant à son extraction hors du connecteur (64).

3. Connecteur selon l'une des revendications 1 ou 2, **caractérisé en ce que** la lèvre (174) est reliée à au moins un bras longitudinal (178) qui par son fléchissement vertical permet des déplacements de la lèvre (174) dans une direction orthogonale au plan de la carte en position introduite.

4. Connecteur selon la revendication précédente, **caractérisé en ce que** la lèvre (174) s'escamote automatiquement lors de l'introduction de la carte (C) dans la mesure où le bord transversal arrière (98) de la carte (C) coopère avec la lèvre (174) qui agit comme une came pour provoquer la déformation élastique du bras (178), la lèvre (174) étant alors en appui contre la portion en vis-à-vis de la carte (C).

5. Connecteur selon l'une quelconque des revendications 2 à 4, **caractérisé en ce que** la carte (C) comporte au voisinage de son bord transversal avant (99) un pan coupé (116) qui constitue un moyen de détrompage de la position de la carte (C) dans le connecteur, et en ce que la lèvre (174) comporte une découpe de profil complémentaire de celui du bord transversal avant (99) de la carte avec un pan coupé (182).

6. Connecteur selon l'une quelconque des revendications précédentes **caractérisé en ce que** le support en matériau isolant (66) comporte un logement (70) ouvert dans sa face supérieure (68), délimité par deux bords (92, 94) parallèles à la direction d'introduction de la carte et transversalement par au moins un bord arrière (96) et qui reçoit au moins en partie la carte (C) comportant sur sa face principale inférieure (72) des plages conductrices (74) qui coopèrent avec les extrémités de contact (76) d'éléments (78) de contact électrique, agencées dans le fond du logement (70) du support, lorsque la carte (C) est dans la position introduite dans laquelle son bord transversal arrière (98) est en butée contre le bord transversal arrière (96) du logement.

7. Connecteur selon la revendication 1, **caractérisé en ce que** des moyens d'extraction de la carte (C) comportent une entaille (114) formée dans une paroi supérieure (44) et qui s'étend parallèlement à la direction (I) d'introduction de la carte (C) pour permettre d'agir sur la carte (C) en vue de provoquer son coulissement à l'intérieur du logement (70) dans le sens correspondant à son extraction.

8. Connecteur selon la revendication 7, **caractérisé en ce que** l'entaille (114) s'étend au moins en partie au droit du bord transversal arrière (98) de la carte (C) lorsque cette dernière est en position introduite pour permettre l'introduction d'un outil d'extraction qui coopère avec le bord transversal arrière de la carte.

9. Connecteur selon la revendication 1, **caractérisé en ce que** des moyens d'extraction de la carte (C) comportent un chariot d'extraction (130) monté coulissant sur le support (66) du connecteur, entre une position introduite de la carte (C) et une position d'extraction dans laquelle la carte fait au moins en partie saillie à l'extérieur, en ce que le chariot d'extraction (130) comporte un bord transversal actif (142) qui s'étend en regard du bord transversal arrière (98) de la carte (C), et en ce qu'il est prévu des moyens de commande des déplacements en coulissement du chariot accessibles depuis l'extérieur.

10. Connecteur selon la revendication 9, **caractérisé en ce que** le chariot d'extraction (130) est rappelé élastiquement (150) vers la position d'extraction de la carte (C).

11. Boîtier (30) de raccordement électronique à parois supérieure (32) et inférieure (34) qui délimitent entre elles une cavité (48) à l'intérieur de laquelle est agencé un connecteur (64) selon l'une quelconque des revendications précédentes et **caractérisé en ce que** le boîtier comporte une fente (80) pour l'introduction, ou l'extraction, de la carte (C) dans le boîtier selon une direction (I) sensiblement parallèle au plan de la carte (C).

12. Boîtier selon la revendication précédente, **caractérisé en ce que**, en position introduite, la carte (C) est agencée entièrement à l'intérieur du boîtier (30).

13. Boîtier selon la revendication précédente, **caractérisé en ce que**, en position introduite dans le boîtier, et ainsi en position de raccordement dans le logement (70) du connecteur (64), le bord transversal avant (99) de la carte est situé entièrement à l'intérieur du boîtier (30), c'est-à-dire légèrement en retrait vers l'intérieur par rapport au bord principal de la fente d'introduction (80).

## Claims

1. Connector (64) for connecting electrically a contact card (C) with integrated circuit(s) to an electronic connection unit which includes a support (66) made of insulating material, said connector including a device (172) which is intended for holding the card in the position in which it is inserted into the connector and **characterised in that** the connector includes a lip (174) having a cut-out whose profile is complementary to that of the front transverse edge (99) of the card, the cut-out and said front transverse edge facing each other in the inserted position, and in that, in order to extract the card, irrespective of whether the extraction mode is manual or automatic, it is necessary to unlock it by acting on the lip (174) in order to move the lip in a direction orthogonal to the plane of the card in the inserted position so as to release the card.

2. Connector according to the preceding claim, **characterised in that**, in the connector, the card (C) is permanently pressed by a spring in a direction corresponding to its extraction from the connector (64).

3. Connector according to one of Claims 1 and 2, **characterised in that** the lip (174) is connected to at least one longitudinal arm (178) which, by bending vertically, allows the lip (174) to move in a direction orthongal to the plane of the card in the inserted position.

4. Connector according to the preceding claim, **characterised in that** the lip (174) retracts automatically when the card (C) is inserted, insofar as the rear transverse edge (98) of the card (C) interacts with the lip (174), which acts as a cam in order to cause the arm (178) to deform elastically, with the lip (174) then bearing against the opposing portion of the card (C).

5. Connector according to any one of Claims 2 to 4, **characterised in that**, in the vicinity of its front transverse edge (99), the card (C) includes a cut-out flap (116) which constitutes an orienting means for the position of the card (C) in the connector, and in that the lip (174) includes a cut-out whose profile is complementary with that of the front transverse edge (99) of the card with a cut-out flap (182).

6. Connector according to any one of the preceding claims, **characterised in that** the support (66) made of insulating material includes an open housing (70) in its upper face (68), delimited by two edges (92, 94), parallel to the insertion direction of the card, and transversely by at least one rear edge (96), and which at least partly receives the card (C) including, on its lower main face (72), conductive zones (74) which interact with the contact ends (76) of electrical contact elements (78) arranged in the bottom of the housing (70) of the support, when the card (C) is in the inserted position, in which its rear transverse edge (98) abuts against the rear transverse edge (96) of the housing.

7. Connector according to Claim 1, **characterised in that** means for extracting the card (C) include a notch (114) which is formed in an upper wall (44) and extends parallel to the insertion direction (I) of the card (C) in order to make it possible to act on the card (C) with a view to causing it to slide inside the housing (70) in the direction corresponding to its extraction.

8. Connector according to Claim 7, **characterised in that** the notch (114) extends at least partly in line with the rear transverse edge (98) of the card (C), when the latter is in the inserted position, in order to allow the insertion of an extraction tool which interacts with the rear transverse edge of the card.

9. Connector according to Claim 1, **characterised in that** means for extracting the card (C) include an extraction carriage (130), mounted so as to slide on the support (66) of the connector between a card (C) insertion position and an extraction position in which the card at least partly projects out of the unit, in that the extraction carriage (130) includes an active transverse edge (142) which extends facing the rear transverse edge (98) of the card (C), and in that means, accessible from outside, are provided for controlling the sliding displacements of the carriage.

10. Connector according to Claim 9, **characterised in that** the extraction carriage (130) is returned elastically (150) towards the card (C) extraction position.

11. Electronic connection unit (30) with upper (32) and lower (34) walls which delimit between them a cavity (48) inside which a connector (64) according to any one of the preceding claims is arranged, **characterised in that** the unit includes a slot (80) for inserting, or extracting, the card (C) into/from the unit in a direction (I) substantially parallel to the plane of the card (C).

12. Unit according to the preceding claim, **characterized in that**, in the inserted position, the card (C) is arranged entirely inside the unit (30).

13. Unit according to the preceding claim, **characterized in that**, in the position in which it is inserted into the unit, and thus in the connection position in the housing (70) of the connector (64), the front transverse edge (99) of the card is situated entirely inside the unit (30), that is to say slightly set back inwards relative to the main edge of the insertion slot (80).

## Patentansprüche

1. Verbinder (64) zum elektrischen Verbinden einer IC-Kärte mit Kontakt (C) mit einem elektronischen Anschlussgehäuse, der einen Träger (66) aus isolierendem Material umfasst, wobei der Verbinder eine Vorrichtung (172) zum Halten der Karte in in den Verbinder eingeführter Position umfasse, **dadurch gekennzeichnet, dass** der Verbinder eine Lippe (174) umfasst, die einen Ausschnitt mit einem zum vorderen Querrand (99) der Karte komplementären Profil hat, wobei der Ausschnitt und der vordere Querrand sich in eingeführter Position gegenüberliegen, und dass zum Entnehmen der Karte sowohl in einem manuellen als auch einem automatischen Entnahmemodus es notwendig ist, eine Entriegelung von dieser durch Einwirken auf die Lippe (174) zu bewirken, um eine Verschiebung der Lippe in einer zur Ebene der Karte in eingeführter Position senkrechten Richtung hervorzurufen, um die Karte freizugeben.

2. Verbinder nach dem vorhergehenden Anspruch, **dadurch gekennzeichnet, dass** in dem Verbinder die Karte (C) durch eine Feder ständig in einer Richtung belastet ist, die ihrer Entnahme aus dem Verbinder (64) entspricht.

3. Verbinder nach einem der Ansprüche 1 oder 2, **dadurch gekennzeichnet, dass** die Lippe (174) mit wenigstens einem longitudinalen Arm (178) verbunden ist, der durch seine vertikale Biegung Verschiebungen der Lippe (174) in einer zur Ebene der Karte in eingeführter Position orthogonalen Richtung erlaubt.

4. Verbinder nach dem vorhergehenden Anspruch, **dadurch gekennzeichnet, dass** die Lippe (174) beim Einführen der Karte (C) sich in dem Maße zurückzieht, wie der hintere Querrand (98) der Karte (C) mit der Lippe (174) zusammenwirkt, die als ein Nocken zum Bewirken der elastischen Verformung des Arms (178) wirkt, wobei die Lippe (174) dann gegen den gegenüberliegenden Abschnitt der Karte (C) drückt.

5. Verbinder nach einem beliebigen der Ansprüche 2 bis 4, **dadurch gekennzeichnet, dass** die Karte (C) in der Nähe ihres vorderen Querrandes (99) eine geschnittene Flanke (116) aufweist, die ein Unverwechselbarkeitsmittel für die Position der Karte (C) in dem Verbinder bildet, und dass die Lippe (174) einen Ausschnitt mit einem zum vorderen Querrand (99) der Karte (C) komplementären Profil mit einer geschnittenen Flanke (182) aufweist.

6. Verbinder nach einem beliebigen der vorhergehenden Ansprüche, **dadurch gekennzeichnet, dass** der Träger aus isolierendem Material (66) eine offene Aussparung (70) an seiner Oberseite (68) aufweist, die durch zwei zur Einführungsrichtung der Karte (C) parallele Ränder (92, 94) und quer durch wenigstens einen hinteren Rand (96) begrenzt ist und die wenigstens zum Teil die Karte (C) aufnimmt, die an ihrer unteren Hauptfläche (72) leitfähige Felder (74) aufweist, die mit den Kontaktenden (76) von elektrischen Kontaktelementen (78) zusammenwirken, die am Boden der Aussparung (70) des Trägers angeordnet sind, wenn die Karte (C) in der eingeführten Position ist, in der ihr hinterer Querrand (98) gegen den hinteren Querrand (96) der Aussparung anschlägt.

7. Verbinder nach Anspruch 1, **dadurch gekennzeichnet, dass** die Mittel zum Entnehmen der Karte (C) einen Einschnitt (114) umfassen, der in einer oberen Wand (44) gebildet ist und sich parallel zur Einführungsrichtung (I) der Karte (C) erstreckt, um auf die Karte (C) einwirken zu können, um ihr Gleiten in der Aussparung (70) in der ihre Entnahme entsprechenden Richtung zu bewirken.

8. Verbinder nach Anspruch 7, **dadurch gekennzeichnet, dass** der Einschnitt (114) sich wenigstens teilweise oberhalb des hinteren Querrandes (98) der Karte (C) erstreckt, wenn letztere in eingeführter Position ist, um das Einführen eines Entnahmewerkzeugs zu ermöglichen, das mit dem hinteren Querrand der Karte (C) zusammenwirkt.

9. Verbinder nach Anspruch 1, **dadurch gekennzeichnet, dass** die Mittel zum Entnehmen der Karte (C) einen Entnahmewagen (130) umfassen, der auf dem Träger (66) des Verbinders zwischen einer eingeführten Position der Karte (C) und einer Entnahmeposition verschiebbar montiert ist, in der die Karte (C) wenigstens zum Teil nach außen vorsteht, und dass der Entnahmewagen (130) einen aktiven Querrand (142) aufweist, der sich gegenüber dem hinteren Querrand (98) der Karte (C) erstreckt, und dass von außen zugängliche Mittel zum Steuern der Verschiebungen des Wagens vorgesehen sind.

10. Verbinder nach Anspruch 9, **dadurch gekennzeichnet, dass** der Entnahmewagen (130) in Richtung der Entnahmeposition der Karte (C) elastisch rückgestellt (150) ist.

11. Elektronisches Anschlussgehäuse (30) mit einer oberen (32) und unteren (34) Wand, die zwischen einander einen Hohlraum (48) begrenzen, in dem ein Verbinder (64) nach einem beliebigen der vorhergehenden Ansprüche angeordnet ist, **dadurch gekennzeichnet, dass** das Gehäuse einen Schlitz (80) zum Einführen oder Entnehmen der Karte (C) in das bzw. aus dem Gehäuse in einer zur Ebene der Karte (C) im wesentlichen parallelen Richtung (I) umfasst.

12. Gehäuse nach dem vorhergehenden Anspruch, **dadurch gekennzeichnet, dass** in eingeführter Position die Karte (C) vollständig innerhalb des Gehäuses (30) untergebracht ist.

13. Gehäuse nach dem vorhergehenden Anspruch, **dadurch gekennzeichnet, dass** in in das Gehäuse eingeführter Position und damit in Anschlussposition in der Aussparung (70) des Verbinders (64) der vordere Querrand (99) der Karte (C) sich vollständig innerhalb des Gehäuses (30) befindet, d.h. in Bezug auf den Hauptrand des Einführungsschlitzes (80) geringfügig nach innen zurückspringt.
